# EUROPEAN PATENT APPLICATION

(11) **EP 2 543 644 A2**
(43) Date of publication of application: **09.01.2013**
(21) Application number: 12175155.6
(22) Date of filing: 05.07.2012
(51) Int. Cl.: C03B 27/04, F24J 2/00

(54) **Physical tempered glass, solar cover plate, solar backsheet and solar panel**

(30) Priority: 06.07.2011 CN 201110198526; 12.12.2011 CN 201110439660
(71) Applicant: Changzhou Almaden Co., Ltd., Changzhou, Jiangsu (CN)
(72) Inventor: Lin, Yuting, 413 Taichung City (TW); Lin, Jinhan, Changzhou Jiangsu (CN); Lin, Jinxi, Changzhou Jiangsu (CN)
(74) Representative: Fluit, Jeroen

(57) **Abstract**

The present invention pertains to a physical tempered glass and a solar panel utilizing the same. The physical tempered glass of the present invention has a thickness of about 0.5 mm to about 2.8 mm, a compressive strength of about 120 MPa to about 300 MPa, a bending strength of about 120 MPa to about 300 MPa and a tensile strength of about 90 MPa to about 180 MPa. The present invention also relates to the preparation of the physical tempered glass and the solar panel.

## Description

### Field of the Invention

The present invention relates to physical tempered glass, and in particular, to physical tempered glass that is thin and has good mechanical properties, thermal stability and transmittance. The present invention also relates to a solar panel, particularly a solar panel comprising the physical tempered glass of the present invention.

### Description of the Related Art

Tempered glass, also referred to as reinforced glass, has superior mechanical properties and thermal stability to common glass. Generally, the tensile strength of common annealed glass is approximately 40 MPa, while that of tempered glass is approximately 120 MPa to 200 MPa, depending on the thickness of the glass, edging processing, and whether it is drilled. Tempering the glass increases its tensile strength. Tempering the glass in advance enables it to bear a temperature difference of about 150°C to 200°C, increases safety, and expands the range of fields in which it can be applied.

Tempered glass is the product of a secondary process applied to flat glass such as float glass or annealed glass, which is produced by forming a compressive stress layer on a glass surface by means of a physical or chemical method, and at the same time, forming a tensile stress layer inside the glass. When the glass is subjected to an external force, the compressive stress layer can offset a part of the tensile stress, thereby protecting the glass against breaking. If a part of the glass is in fact damaged, the stress is released, so that the glass is broken into numerous small blocks that pose relatively little hazard due to lack of sharp edges and corners.

Tempered glass can be classified as either physical tempered glass or chemical tempered glass, depending on the processing method.

Physical tempered glass, also referred to as quenched and tempered glass, is formed through the following steps: common flat glass is cut into a desired size, edged or drilled, placed on a roller table, pushed into a tempering furnace, and heated to a temperature close to the softening temperature of glass (about 600°C to 650°C) to eliminate internal stresses through deformation in the glass. The glass is removed from the tempering furnace and subjected to high-pressure cold air from a multiple head nozzle for both sides of the glass to quickly and evenly cool to room temperature. After cooling, a compressive stress is formed on the glass surface, and a tensile stress is formed inside the glass, thus achieving the purpose of improving the strength of the glass. As the chemical composition of glass is unchanged in this tempering method, the glass obtained is referred to as physical tempered glass.

The strength of physical tempered glass is generally 3 to 5 times higher than that of common glass. Physical tempered glass is the most commonly used glass in the market due to the simplicity of the process, as well as the low cost and long lifetime of the product, which generally lasts up to 20 years. However, as a practical limitation of heating by means of a roller table, physical tempered glass should be thicker than 3 mm; otherwise, deformation occurs. Nevertheless, thicker glass requires concomitant increase in weight, transportation cost, and load pressure on support elements such as the roof of a building. This imposes restrictions on use. Additionally, the thicker the glass, the poorer the transmittance.

In chemical tempered glass, the chemical composition of the glass surface is changed to improve its strength. Generally, the glass is chemically tempered through a method such as surface dealkalization or alkali metal ion exchange method. As the ingredients contained in the glass surface are changed in the chemical tempering method, the glass has a high pressure resistance like physical tempered glass.

Chemical tempered glass is about 9 to 15 times stronger than normal glass, and imposes no processing limitations on thickness. However, chemical tempered glass is easily damaged due to environmental factors. Moreover, it is difficult to apply subsequent coatings to the glass, and film stripping easily occurs, so its lifetime is shorter, generally less than 10 years. In addition, manufacturing cost is high. The above factors restrict the range of application of chemical tempered glass.

Accordingly, the present invention provides a solution for the abovementioned problems. The inventors of the present invention found that thin physical tempered glass can be obtained by tempering the glass through aerodynamic heating. The method do not degrade the mechanical properties, thermal stability, and transmittance of the tempered glass and can even improve them, so as to meet demands in specific fields, particularly for the cover plate or backsheet of a solar cell.

The solar cover plate, which is the most upper part of a solar panel, requires good mechanical properties, thermal stability and transmittance so as to increase the efficiency of the photovoltaic cell layer. A conventional solar cover plate, which is thick and heavy, limits the application of the solar panel because some roofs cannot withstand the heavy loads.

As for the solar backsheet, it is at the bottom of a solar panel and is the main support for the entire solar panel. To prolong the lifetime of a solar panel, a solar backsheet should also protect the solar devices inside the panel from water, moisture, oxidation, thermal deformation and electrical leakage. In addition, during assembly, the solar backsheet may restrain the photovoltaic devices from moving around, provide electrical isolation, and prevent mechanical damage to the devices (such as scratches). Moreover, heat dissipation capacity is also an important feature of a good solar backsheet.

A conventional solar backsheet usually has one of the following structures:
Polyvinyl fluoride(PVF)/adhesive/polyethylene terephthalate (PET)/adhesive/PVF;
PVT/adhesive/PET;
PVF/adhesive/aluminum foil/adhesive/PET;
PET/adhesive/SiO₂ PET; and
Coating/PET/adhesive/ethylene vinyl acetate(EVA) primer.

Among the above, PVF/adhesive/PET/adhesive/PVF (i.e., TPT) structure is the most common, and occupies approximately 70% of the market.

The above structures for a solar backsheet all employ a PVF or PET layer as a substrate. PET substrates are popular due to good mechanical properties, electrical isolation properties, temperature tolerance (from -70°C to 120°C), thermal stability in terms of mechanical properties and very low gas and moisture permeability. In addition to good mechanical and isolation properties and temperature tolerance (up to 260°C), the popularity of PVF is attributable to its excellent anti-UV ability and high chemical stability due to high energy C-F bonds. According to DuPont ® U.S.A, the PVF film under the brand name Tedlar® has an expected lifetime of more than 25 years.

Glass also has good weatherability and isolations, making it potentially suitable for use as a solar backsheet. In fact, in early development of solar technology, the solar backsheet was normally made of glass. However, due to poor mechanical properties and processability, glass became superseded by polymeric materials. In contemporary practice, the application of glass in solar technology is limited to the cover plate only.

Still, glass has certain properties that are superior to those of polymeric materials, particularly in terms of stability. If its mechanical properties can be improved, glass could become a suitable material for use in a solar backsheet.

Accordingly, the present invention provides a solar backsheet with a physical tempered glass as the substrate. The solar backsheet of the present invention has good mechanical properties, weatherability and electrical isolation and certain advantages not found in a solar backsheet with a polymeric substrate.

### Summary Of the Invention

The first aspect of the present invention is to provide a physical tempered glass that is thin and has good mechanical properties, thermal stability and transmittance. The physical tempered glass is applicable in many fields, for example, in optical glass, automotive glass, architectural glass, decorative glass, aviation glass, and especially in a solar panel.

The second aspect of the present invention is to provide a method for manufacturing the physical tempered glass, which includes performing aerodynamic heating on glass.

The third aspect of the present invention is to provide a solar panel comprising the thin physical tempered glass mentioned above as the cover plate or the backsheet substrate or both. The solar panel of the present invention has good mechanical properties, thermal stability and transmittance, and can effectively improve the efficiency of photovoltaic cells and significantly reduce overall weight, thereby reducing cost while also expanding potential range of application.

The fourth aspect of the present invention is to provide a method for manufacturing the solar backsheet or the solar panel mentioned above.

The fifth aspect of the present invention is to provide a solar backsheet structure having good heat dissipation and a method of manufacturing the same, wherein the solar backsheet structure includes a heat dissipation layer disposed on the outer surface of the glass substrate.

### Brief Description of the Drawings

Fig. 1 is a schematic view of the solar backsheet structure of the present invention. Reference number 10 refers to a glass substrate, 20 refers to a reflection layer, 30 refers to a buffer layer and 40 refers to an encapsulant layer. A heat dissipation layer 50 can be optionally disposed on the outer surface of the glass substrate 10.
Fig. 2 is a schematic ray diagram in the solar backsheet of the present invention. Scattering can be increased by texturing the surface of the glass substrate.

### Detailed Description of the Invention

In this specification, unless otherwise specified, singular forms "a(n)" and "the" also include the plural forms. All embodiments and exemplary terms (such as "for example") in this specification are merely intended to illustrate the present invention in more detail, not to limit the scope of the present invention, and terms in the specification should not be construed as implying that any components that are not claimed are necessary components required for practicing the present invention.

The physical tempered glass of the present invention is thinner than commercial physical tempered glass. The physical tempered glass of the present invention has a thickness of about 0.5 mm to about 2.8 mm, preferably a thickness of about 1.0 mm to about 2.5 mm, and more preferably a thickness of about 1.5 mm to about 2.0 mm, depending on the application requirements of the product. The description of the abovementioned ranges should be considered to have disclosed any subranges. For example, the range of about 1.0 mm to about 2.5 mm includes about 1.2 mm to about 2.2 mm, or about 1.3 mm to about 2.3 mm.

Additionally, the physical tempered glass of the present invention has good mechanical properties, including a compressive strength of about 120 MPa to about 300 MPa, and preferably a compressive strength of about 150 MPa to about 250 MPa, a bending strength of about 120 MPa to about 300 MPa, and preferably a bending strength of about 150 MPa to about 250 MPa, and a tensile strength of about 90 MPa to about 180 MPa, and preferably a tensile strength of about 100 MPa to about 150 MPa.

In addition, the physical tempered glass of the present invention has excellent transmittance. The transmittance is generally related to the thickness of the glass. In an embodiment of the present invention, physical tempered glass substrate having a thickness of about 2.0 mm has a transmittance of about 92% to about 93%.

In an embodiment of the present invention, the method for manufacturing the physical tempered glass includes:
providing flat glass having a thickness of about 0.5 mm to about 2.8 mm;
performing aerodynamic heating on the flat glass; and
cooling the flat glass.

In the present invention, suitable flat glass is known to persons of ordinary skill in the art, and can be manufactured through any conventional method. For example, the flat glass can be but is not limited to, float glass or annealed glass.

In the present invention, the term "aerodynamic heating" refers to a process whereby a high-temperature gas generated when an object performs high-speed relative motion with respect to the air or other gases transfers heat to the object. In a preferred embodiment of the present invention, the aerodynamic heating is performed in an aerodynamic heating temperature tempering furnace, for example, LiSEC's flatbed tempering furnace (manufactured by LiSEC Company).

In an embodiment of the present invention, the heating temperature of the aerodynamic heating is about 600°C to about 750°C, and preferably about 630°C to about 700°C.

In the present invention, a method for cooling the flat glass is known to persons of ordinary skill in the art, and preferably includes a rapid cooling with air from a jet nozzle.

In an embodiment of the present invention, the method for manufacturing the physical tempered glass may optionally include other steps, for example, cutting the flat glass into a desired size, and edging or drilling before the aerodynamic heating ; forming a coating, for example, but not limited to, an anti-reflection layer, a transparent conductive film, a transparent metal oxide film, a compound film, or a metal film, on the flat glass before the aerodynamic heating ; and forming a coating, for example, but not limited to, an anti-reflection layer, a transparent conductive film, a transparent metal oxide film, a compound film, or a metal film, on the flat glass after cooling the glass.

In a preferred embodiment of the present invention, after forming a coating, the glass may be heated in a heating furnace and cooled to increase the adhesion between the coating and the glass, in which a temperature of the heating furnace is, for example, but not limited to, about 100°C to about 600°C, and preferably about 250°C to about 400°C.

In the present invention, aerodynamic heating is used to temper the glass, in which the glass does not directly contact the tempering furnace, and no deformation of the glass occurs, so it is suitable for tempering thin glass. In addition, the physical tempered glass manufactured through the method mentioned above in the present invention has good mechanical properties, thermal stability and transmittance, and is applicable in many fields, such as optical glass, automotive glass, architectural glass, decorative glass, and aviation glass, especially in a glass substrate of a solar panel, hollow glass, heat insulating glass, or soundproof glass, and most preferably in a solar panel.

### Solar panel

The present invention further provides a solar panel comprising:
a first substrate,
a photovoltaic cell layer, and
a backsheet comprising a second substrate, an anti-reflection layer, a buffer layer and an encapsulant layer,
wherein the first substrate or the second substrate or both are the physical tempered glass of the present invention.

In the solar panel of the present invention, the photovoltaic cell layer is known to persons of ordinary skill in the art. In an embodiment of the present invention, the photovoltaic cell layer is selected from the group consisting of a wafer-based photovoltaic cell layer and a thin film-based photovoltaic cell layer, for example, but not limited to, a monocrystalline silicon photovoltaic cell layer, a polysilicon photovoltaic cell layer, a gallium arsenide photovoltaic cell layer, an amorphous silicon photovoltaic cell layer, a cadmium telluride photovoltaic cell layer, a copper indium selenide photovoltaic cell layer, a copper indium gallium selenide photovoltaic cell layer, and a dye-sensitized photovoltaic cell layer. The individual cells in the photovoltaic cell layer are connected in series or parallel and further connected to a lead wire.

The solar panel of the present invention may optionally include other elements, for example, but not limited to, an anti-reflection layer, heat insulating layer, or a heat absorbing plate.

### Solar cover plate

Due to its good mechanical properties, high transmittance and light weight, the physical tempered glass of the present invention is particularly suitable for use as the cover plate of a solar panel.

The solar panel of the present invention uses a physical tempered glass of about 0.5 mm to about 2.8 mm as a glass substrate, as compared with the conventional glass substrate of about 3.0 mm or about 4.0 mm, thereby reducing volume and weight by about 7% to about 88%, preferably about 40%, and thus reducing the overall weight and volume of the solar panel, leading in turn to reduction of packaging and transportation costs, and reducing load on electricity pylons, roofs, and other structures. Keeping other processes and production conditions constant, the solar panel of the present invention enjoys greatly reduced cost of production, transportation, and installation, and can reap on-grid tariffs close to those for thermal power, thereby achieving huge economic benefits.

Nevertheless, it should be noted that conventional materials such as normal glass, acrylic resins, fluorinated ethylene propylene, transparent polyester and polycarbonate can still be used for the solar cover plate in the present invention when the substrate for the solar backsheet is the physical tempered glass of the present invention.

### Solar backsheet

The solar backsheet of the present invention has a structure sequentially comprising:
a glass substrate, which is the physical tempered glass of the present invention,
a reflection layer,
a buffer layer,
an encapsulant layer,
and optionally a heat dissipation layer disposed on the outer surface of the glass substrate.

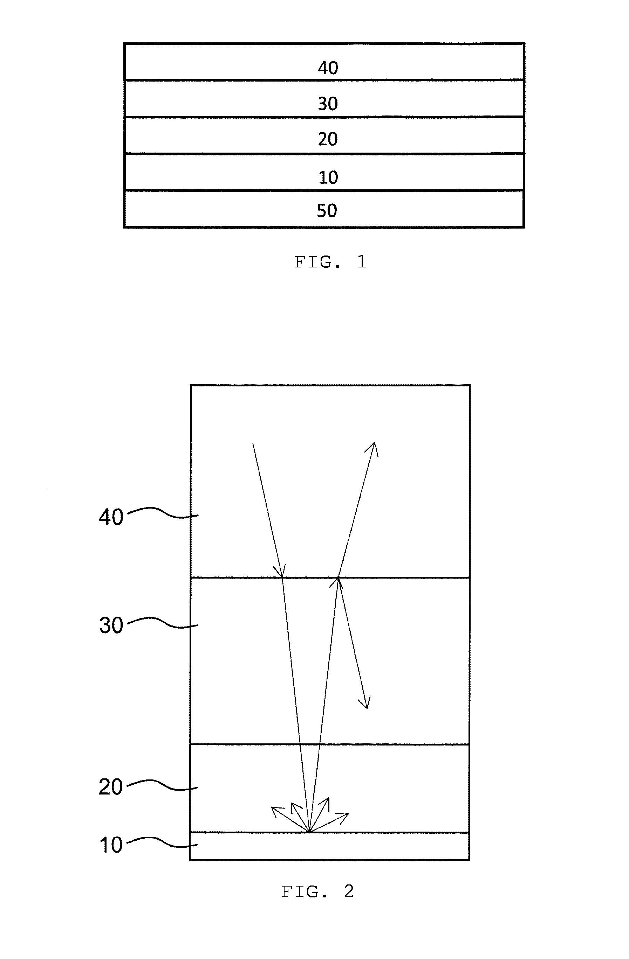

The solar backsheet structure of the present invention is schematically illustrated in Fig. 1, in which 10 refers to a glass substrate, 20 refers to a reflection layer, 30 refers to a buffer layer and 40 refers to an encapsulant layer.

The technical features and manufacture of each layer in the solar backsheet structure of the present invention are further described as follows.

### (1) Glass substrate

No conventional glass is suitable for use as the substrate in the solar backsheet of the present invention. The mechanical properties of normal glass cannot meet the requirements for a solar backsheet and therefore render it unsuitable. Moreover, while conventional physical tempered glass might have certain required mechanical properties, it must be no less than 3 mm thick to avoid deformation, a limitation that not only increases the cost of materials and transportation but also decreases efficiency of heat dissipation. In addition, while conventional chemical tempered glass might meet the requirements for mechanical properties and thickness, it has certain drawbacks such as being prone to damage from environmental factors, difficulty in subsequent coatings, being prone to film stripping and higher cost; therefore its range of potential application is limited.

Furthermore, although the solar backsheet structure of the present invention comprises a reflection layer on the glass substrate, light might still permeate through the thin reflection layer and reach the glass substrate. To increase reflection, texturization may be performed on the surface of the glass substrate that the reflection layer is disposed on to reflect the light rays back via scattering. The method of texturization can be for example, but is not limited to, sandblasting, embossing, etching or laser scribing.

### (2) Reflection layer

To increase the efficiency of the solar cell, the solar backsheet structure of the present invention comprises a reflection layer. Theoretically, the refractive index of the reflection layer should be greater than that of the buffer layer. Preferably, the reflection layer has a refractive index of 2.0 or more.

The reflection layer is mainly for reflecting light rays, so the material used is not particularly limited. Preferably, the reflection layer is made of metals such as Ag, Au, Al and Cr. Metal oxides or non-metals such as TiO₂, BaSO₄ and Teflon can also be used. The above listed metal oxides or non-metals are preferred because they all have a white appearance and thus efficiently increase reflection.

The thickness of the reflection layer is not particularly limited. Generally, a thickness of 20 nm to 2000 nm would be appropriate.

In an embodiment of the present invention, the reflection layer is Ag or Al foil having a thickness of 100 nm.

The reflection layer is applied to the glass substrate by any suitable methods, for example, adhering the reflection layer to the glass substrate by using adhesives.

When a metal is used, it can be directly deposited on the glass substrate by physical vapor deposition. This method requires no adhesives and so is preferred, as the process is relatively simple and can prevent problems caused by degradation of adhesives. This is one of the advantages of the present invention over a conventional solar backsheet with polymeric substrate.

The reflection layer can be applied to the glass substrate before or after glass tempering by aerodynamic heating.

### (3) Buffer layer

Above the reflection layer is a buffer layer. The buffer layer functions as a spacer between the reflection layer and the encapsulant layer to avoid defects due to undesired reaction (for example, when the encapsulant layer is made of EVA and the reflection layer is a metal foil, the acetic acid in the encapsulant layer might react with the metal and generate acetates). Accordingly, the buffer layer must be made of a material that is inert to both the encapsulant layer and the reflection layer.

To allow the light rays reflected from the reflection layer to advance to the encapsulant layer, the buffer layer should have a refractive index between that of the reflection layer and encapsulant layer (as shown in Fig. 2). Specifically, the buffer layer should have a refractive index of 1.4 to 2.0, preferably 1.48 to 1.9.

Accordingly, suitable materials for the buffer layer include, but are not limited to, SiO₂, SiNₓ, Al₂O₃, MoO₃, WO₃, MnO₂, ZnO or SnO₂.

The thickness of the buffer layer is not particularly limited. Generally, 20 nm to 200 nm is appropriate and 50 nm to 100 nm is preferred.

The buffer layer can be attached to the reflection layer by any suitable methods, for example, chemical vapor deposition or coating. Normally, a relatively thin and good quality film can be obtained by chemical vapor deposition.

### (4) Encapsulant layer

An encapsulant layer mainly serves to fix the photovoltaic devices in a solar panel. An encapsulant layer also provides physical (e.g., impact or moisture) protection to the photovoltaic devices. The encapsulant layer of the present invention can be any suitable materials known in the art, for example, EVA.

EVA, which is the most common encapsulant material for solar panels, is a thermoset resin. EVA is an ideal material for encapsulant due to its good transmittance, resistance to high and low temperature and moisture, and weatherability as well as its satisfactory elasticity, impact resistance and heat dissipation and good adhesion to metals, glass and plastics. EVA has a refractive index of 1.4 to 1.5, normally 1.48. A common EVA layer has a thickness of about 0.4 cm to 0.6 cm, preferably 0.45 cm.

The encapsulant layer of the present invention can be adhered to the buffer layer by any suitable methods. When EVA is used, it can be adhered to other materials by heat-lamination.

### (5) Heat dissipation layer

Currently, solar cells achieve conversion efficiency of only 10% to 20%. Most photo energy is converted to waste heat and accumulated in the solar panel, which could cause failure. As the cover plate faces the sun and is correspondingly hotter, heat energy must be removed from the backside of the solar panel. Accordingly, heat dissipation capacity becomes an important attribute of a solar backsheet.

As the solar backsheet of present invention employs glass as the substrate, materials with high heat transfer rate, for example, metals including copper and aluminum, or other materials including AIN, SiN and SiC, can be directly coated or deposited on its outer surface.

It should be understood that the descriptions in the specification and drawings are for illustrating the present invention only, not for limiting the scope of the invention, and any alternative or equivalent arrangements that can be easily performed by persons skilled in the art all would fall within the scope of the present invention.

### EXAMPLE 1

### Preparation of physical tempered glass of the present invention

A large piece of annealed glass was cut into a size of 2 m in length, 1 m in width and 2 mm in thickness, subject to edge grinding, drilled at certain positions for junction box installation, cut into a desired shape, and then delivered to LiSEC's flatbed tempering furnace (manufactured by LiSEC Company) and heated by air of about 600°C. The glass was removed from the flatbed tempering furnace, both sides subjected to high-pressure cold air from a multiple head nozzle to be quickly and evenly cooled to room temperature.

In the present invention, the glass is tempered through aerodynamic heating, which is very suitable for tempering thin glass. Additionally, in the present invention, the physical tempered glass obtained through aerodynamic heating has good mechanical properties, thermal stability and transmittance, is applicable in various fields, especially in a solar panel, can effectively improve the efficiency of the photovoltaic cell layer and produce more power, and can bear great wind pressure and a large temperature difference between day and night; moreover, the present invention achieves reductions in overall weight and costs, thereby expanding its range of potential application.

It should be understood that the present invention is not limited to the exemplary embodiments described in the specification. Without departing from the scope and principle of the present invention, alternations and modification that are obvious to persons skilled in the art would fall within the scope of the specification and claims.

## Claims

1. A physical tempered glass, having a thickness of about 0.5 mm to about 2.8 mm, a compressive strength of about 120 MPa to about 300 MPa, a bending strength of about 120 MPa to about 300 MPa, and a tensile strength of about 90 MPa to about 180 MPa.

2. The physical tempered glass according to Claim 1, having a thickness of about 0.5 mm to about 2.0 mm, a compressive strength of about 150 MPa to about 250 MPa, a bending strength of about 150 MPa to about 250 MPa, and a tensile strength of about 100 MPa to about 150 MPa.

3. The physical tempered glass according to Claim 1 or 2 for use in optical glass, automotive glass, architectural glass, decorative glass, aviation glass or as a glass substrate of a solar panel, hollow glass, heat insulating glass, or soundproof glass.

4. A method for manufacturing a physical tempered glass comprising:
providing flat glass having a thickness of about 0.5 mm to about 2.8 mm;
performing aerodynamic heating on the flat glass; and
cooling the flat glass.

5. The method according to Claim 4, wherein the aerodynamic heating is performed in an aerodynamic heating tempering furnace at a temperature of about 630°C to about 700°C.

6. A solar backsheet structure sequentially comprising:
the physical tempered glass according to any of Claims 1 to 3;
a reflection layer;
a buffer layer; and
an encapsulant layer.

7. The solar backsheet structure according to Claim 6, wherein the surface of the glass substrate with the reflection layer disposed thereon is textured.

8. The solar backsheet structure according to Claim 6 or 7, wherein the reflection layer comprises TiO2, BaSO4, Teflon ®, Ag, Au, Al, Cr or a combination thereof, or a material having a refractive index of 2.0 or more.

9. The solar backsheet structure according to any of Claims 6 to 9, wherein the buffer layer comprises SiO2 SiNx, Al2O3, MoO3, W03, MnO2, ZnO, SnO2 or a combination thereof, or a material having a refractive index of 1.4 to 1.9.

10. The solar backsheet structure according to any of Claims 6 to 9, wherein a heat dissipation layer is disposed on the surface of the glass substrate opposite the reflection layer.

11. The solar backsheet structure according to any of Claims 6 to 10, wherein the heat dissipation layer comprises a metal, AIN, SiN, SiC or a combination thereof and is formed by direct coating or deposition.

12. A solar panel comprising:
a first substrate;
a photovoltaic cell layer;
a solar backsheet structure comprising a second substrate, a reflection layer, a buffer layer, and an encapsulant layer, wherein the first substrate or the second substrate or both comprises the physical tempered glass according to any of Claims 1 to 3.

13. The solar panel according to Claim 12, comprising a heat dissipation layer disposed on the surface of the second substrate opposite the reflection layer.

14. A method for manufacturing a solar panel comprising the steps of:
providing a first substrate,
forming a photovoltaic cell layer on the first substrate; and
disposing a solar backsheet structure comprising a second substrate, a reflection layer, a buffer layer and an encapsulant layer on said photovoltaic cell layer, wherein the first substrate or the second substrate or both comprise the physical tempered glass according to any of claims 1 to 3.

15. The method of Claim 14, comprising directly coating or depositing a heat dissipation layer on the surface of the second substrate opposite the reflection layer.
